Europäisches Patentamt

(19) European Patent Office    (11) Publication number:    **0 094 041**

Office européen des brevets    **B1**

(12)    **EUROPEAN PATENT SPECIFICATION**

(45) Date of publication of patent specification: 26.08.87    (51) Int. Cl.⁴: **G 03 B 41/00**

(21) Application number: **83104432.6**

(22) Date of filing: **05.05.83**

(54) Reduction projection aligner system.

(30) Priority: **07.05.82 JP 75265/82**

(43) Date of publication of application:
**16.11.83 Bulletin 83/46**

(45) Publication of the grant of the patent:
**26.08.87 Bulletin 87/35**

(84) Designated Contracting States:
**DE FR GB**

(56) References cited:
**EP-A-0 019 941
DE-B-2 651 430
US-A-3 943 359
US-A-4 153 371
US-A-4 172 664**

**Patent Abstracts of Japan Vol. 4, no. 75, 31
May 1980 Page 14E13
IEEE TRANSACTIONS ON ELECTRON
DEVICES, vol. ED-26, no. 4, 1979 G. BOUWHUIS
et al. "Automatic alignment system for optical
projection printing", pages 723-728**

(73) Proprietor: **HITACHI, LTD.**
**6, Kanda Surugadai 4-chome Chiyoda-ku
Tokyo 100 (JP)**

(72) Inventor: **Kuniyoshi, Shinji**
**2-11-7, Hounan
Suginami-ku Tokyo (JP)**
Inventor: **Takanashi, Akihiro**
**1-28-32, Fujimoto
Kokubunji-shi Tokyo (JP)**
Inventor: **Hosaka, Sumio**
**2196-657, Hirai Hinodemachi
Nishitama-gun Tokyo (JP)**
Inventor: **Kawamura, Yoshio**
**2-3-2-1407, Minamisuna
Koutou-ku Tokyo (JP)**
Inventor: **Kurosaki, Toshiei**
**3-9-11-709, Nakakasai
Edgawa-ku Tokyo (JP)**
Inventor: **Terasawa, Tsuneo**
**2-32-E404, Koyasu-cho
Hachioji-shi Tokyo (JP)**

(74) Representative: **Altenburg, Udo, Dipl.-Phys.**
**et al
Patent- und Rechtsanwälte Bardehle-
Pagenberg-Dost-Altenburg & Partner Postfach
86 06 20
D-8000 München 86 (DE)**

## Description

The present invention relates to a reduction projection aligner system which forms a microscopic pattern on a wafer in a semiconductor manufacturing process.

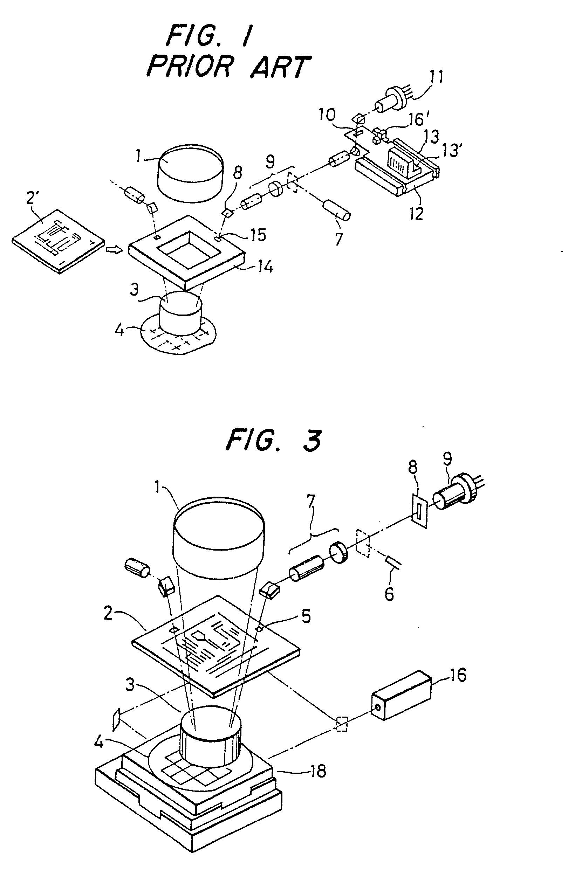

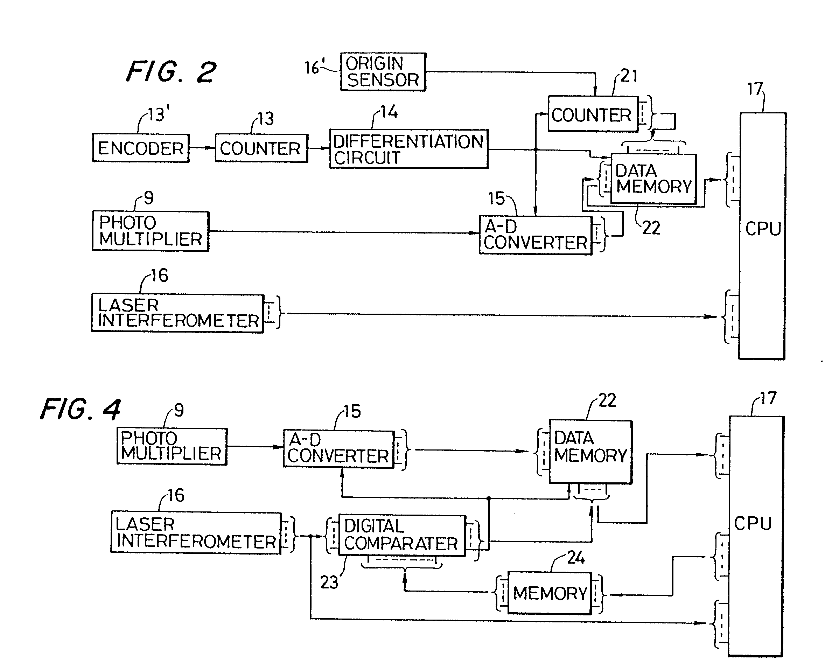

In general, the reduction projection aligner system is used for semiconductor technologies and forms the patterns of semiconductor integrated circuits, such as ICs and LSIs, directly on wafers. Ordinarily, a circuit pattern on an original called "reticle", to be reproduced anew, is printed in superposition on the circuit pattern of a wafer formed by a preceding step, and such superpositional printing operations are successively repeated for several reticles, thereby to form a desired circuit pattern on the wafer. At this time, the pattern on the reticle to be reproduced anew needs to be positioned at high precision to the pattern formed on the wafer by the preceding step, as illustrated in Figure 1. A pattern positioning method will be described in detail by taking as an example a reduction projection aligner system as defined in the precharacterizing part of claim 1 and as known e.g. from EP—A—0019941, Figure 2 which corresponds to Figure 1 of this application. In this system, the position of a pattern on a wafer 4 formed by a preceding step is detected, and a reticle 2' having a pattern to be reproduced anew is relatively moved so as to register with the wafer 4, whereby the pattern alignment is effected. More specifically, a pattern for positioning (not shown) on the wafer 4 is locally illuminated by a light guide 7. The resulting reflected light passes through a reduction lens 3, and a hole 15 provided in a mount 14. This pattern is magnified and imaged on the moving plane of a carriage 12 having a slit 10, through a magnifying optical system 8, 9. A variation in the luminous flux passing through the slit, which arises with the reciprocating motion of the slit 10, is photoelectrically converted by a photomultiplier 11, and the wafer position can be found by, for example, a method stated hereunder (refer to JP—A—53—69063, corresponding to US—A—4,115,762). With an arbitrary position $X_i$ of the slit as a virtual center, data on both the sides thereof in a number of 2·m are superposed to calculate

$$Z_i = \sum_{j=1}^{m} (Y_{i+j} - Y_{i-j})^2$$

where $Y_i$ denotes an output signal at the position $X_i$. In the variation of the values Z thus obtained, a point affording the minimum value of Z is deemed the central position of the positioning pattern on the wafer. In such system, the central position of the positioning pattern on the wafer relative to an origin sensor 16' disposed on the system proper and serving as reference of the pattern positioning is found. In Figure 1, numeral 1 designates a condensing lens for pattern exposure, and numeral 13' an encoder for use in measuring the slit position.

An example of a signal processing circuit in the prior art having the above-stated setup is shown in Figure 2. An output from the encoder 13' for measuring the slit position is applied to a counter 13, the output of which is applied to a differentiation circuit 14. Using the output pulse of the differentiation circuit as a synchronizing signal, an A-D (analog-to-digital) converter 15 is started. A digital signal produced by the converter 15 is transmitted to a data memory 22. On the other hand, the synchronizing pulses enter a counter 21 and are converted into a digital quantity for determining the address of the data memory 22. The digital quantity is transmitted to the memory 22 so as to hold therein the luminous flux variation corresponding to the positional information. The timing at which the signal is fed into the data memory 22, is determined by the synchronizing pulse. The start position of the addresses is determined by the output pulse of the origin sensor 16'. The information stored in the data memory 22 as described above are transmitted to a CPU (central processing unit) 17 by a control signal in this CPU 17. On the basis of such data, the relative position between the wafer position with reference to the origin sensor 16' of a pattern detector is detected by employing the method stated before. The position of a movable stage on which the wafer is placed is measured by a laser interferometer 16 (not shown in Figure 1). The resulting signal is applied to the CPU 17, and is compared with the wafer position detected as described above. In accordance with the result of the comparison, the wafer is moved and positioned to a predetermined position.

The above method, however, requires a reciprocating scanning mechanism for the instrument for measuring the movement value of the slit, for example, the encoder 13' and the slit 10. Consequently, the system setup becomes complicated and large in size, and high-speed detection is difficult because of the limitation of the response frequency of the slit position measuring instrument. Another disadvantage is that the high-precision measurement of the slit position becomes difficult due to the vibrations of the whole system, etc., so the detection accuracy of the pattern degrades.

The present invention has been made in view of the above drawbacks, and has for its object to provide a reduction projection aligner system which realizes the high-speed and high-precision positioning of patterns.

This object is accomplished according to the invention by a reduction projection aligner system as defined in claim 1. Further advantageous embodiments of this system are mentioned in claims 2 and 3.

Figure 1 is a schematic view showing an example of a prior-art reduction projection aligner system;

Figure 2 is a signal flow chart in a prior-art method;

Figure 3 is a schematic view showing an embodiment of the present invention; and

Figure 4 is a signal flow chart for the present invention. .

Now, the present invention will be described in detail in conjunction with embodiments.

Figure 3 illustrates the concept of an embodiment of the present invention. In the embodiment, unlike the prior-art setup shown in Figure 1, a slit 8 is fixedly installed on a system proper and serves as a reference for the detection of a wafer position. A pattern on a wafer is projected on the fixed slit, and the luminous flux of the slit passing light of a projection image appearing with the movement of the wafer is photoelectrically converted by a photomultiplier 9. A positioning pattern (which is not shown and which is, for example, a rectilinear pattern) on the wafer 4 is locally illuminated by a light guide 6. The resulting reflected light is magnified and imaged on the slit 8 through a reduction lens 3, a reference pattern 5 on a reticle 2, and a magnifying optical system 7. At this time, the luminous flux of the slit passing light of the projected image is photoelectrically converted by the photomultiplier 9. Such magnified image moves on the slit with the movement of a movable stage 18 on which the wafer 4 is placed. A magnified image profile can be obtained by photoelectrically converting the slit passing light with reference to the output of a high-precision length measuring instrument for the movable stage, for example, a laser interferometer 16. In this manner, according to the embodiment, the slit 8 is fixed on the optical axis of the magnifying optical system 7, whereby the projected image on the optical axis is photoelectrically converted at all times. It is therefore possible to obtain a detection signal which is not affected by the distribution of the intensities of illumination in the local illumination on the wafer.

Figure 4 shows an example of a practicable circuit arrangement which detects the pattern position of the wafer by the use of the detection signal indicative of the magnified image profile and a signal indicative of the positional information of the stage carrying the wafer. As compared with the prior art shown in Figure 2, the illustrated embodiment is characterized in that the data of the laser interferometer are adopted as the positional information. Referring to Figure 4, the positional data from the laser interferometer 16, occasionally measured in accordance with the movement position of the movable stage with the wafer drawn thereon by suction, and a data feed start position data set in a memory 24 by a CPU 17 are digitally compared in a digital comparator 23, and the value of the resulting deviation is transmitted to a data memory 22 as an address information.

On the other hand, a pulse obtained from any desired bit of the deviation value is transmitted to an A/D converter 15 and the data memory 22 as synchronizing pulses, to start the A/D converter 15 and data memory 22. Thus, the analog signal outputted from the photomultiplier 9 and indicating the magnified image profile of the positioning pattern on the wafer is converted into a digital quantity, which is stored in the data memory 22. In this way, the photomultiplier signal for the wafer position is held in the data memory 22 without the scanning of the slit. The held data is transmitted to the CPU 17 by the control signal of this CPU 17, and the pattern position on the wafer is determined by a known method (for example, the foregoing method disclosed in JP—A—53—69063).

As thus far described, the positioning pattern on the wafer is magnified through the optical lenses and then imaged on the slit, the stage carrying the wafer thereon is moved, and the luminous flux of the slit passing light of the magnified image on the imaging plane is photoelectrically detected, whereby the position of the wafer relative to the slit, in other words, the system proper is measured at high precision. Thereafter, the wafer and the reticle are positioned, the latter having been positioned to the system proper by another detecting optical system.

It is considered that the slit position in the above embodiment is fixed on the system proper so as to coincide with, for example, the central position of the reference pattern 5 on the reticle. As an expedient therefor, it is considered by way of example that the slit is installed on a carriage as shown in Figure 1, and that the carriage is fixed at an encoder output position indicative of the central position of the reference pattern on the reticle. Alternatively, the reticle is moved orthogonally to the slit in the setup of Figure 1, and slit passing light corresponding to the reference pattern position on the reticle is sampled, whereby the relative position between the central position of the reference pattern of the reticle and the slit position can be found.

The slit position is fixed on the system proper by the use of the reticle provided with the reference pattern, so as to coincide with the central position thereof. Once the slit position has been fixed with reference to the wafer position, such reference pattern on the reticle is not always needed especially, and it is only required that the peripheral part of the reticle can transmit light.

According to the present invention, the luminous flux of the light having passed through the slit thus fixed is photoelectrically converted and sampled at intervals of, e.g., 0.016 µm in terms of the laser interferometer output with reference to the position of the wafer drawn on the stage by suction, and the processing stated before is performed, whereby the wafer position can be detected at high resolution.

As a result, in contrast to the prior art wherein the detection accuracy is 0.2 µm and the detection time is 1.0 second or so, the present invention has realized a reduction projection aligner system having a high-speed and high-accuracy pattern detecting function wherein the detection accuracy is 0.1 µm and the detection time is 0.1 second. Needless to say, the present invention is applicable to apparatuses for measuring the dimensions of micropatterns on wafers, etc.

**Claims**

1. A reduction projection aligner system wherein a pattern (5) on a reticle (2) is reduced and projected on a wafer (4), the projection light directly forming the pattern thereon, comprising means (3, 7) to optically magnify and project a positioning pattern formed on the wafer (4) and to image it on an imaging plane having slit means (8), stage means (18) to place the wafer (4) thereon and being movable in a predetermined direction, length measuring means (16) to measure the position of the stage means (18) in the said direction and means (9) to measure photoelectrically the luminous flux of the light passing the slit means (8) and means (15, 16, 17, 22, 23, 24) to calculate the relative position between the positioning pattern on the wafer (4) and the slit means (8), characterized in that the slit means (8) is fixedly mounted on the optical axis of the magnifying system (7) and that the relative position between the positioning pattern on the wafer (4) and the slit means (8) is detected by photoelectrically measuring the luminous flux of the light passing the slit means (8) in dependence upon the movement of the stage means (18).

2. A reduction projection aligner system according to claim 1, characterized by means to move and position the reticle (2) having the pattern to be formed anew, so as to coincide with the position of the wafer (4).

3. A reduction projection aligner system according to claim 1 or 2, characterized in that the length measuring means comprises a laser interferometer (16).

**Patentansprüche**

1. Ausrichtsystem für eine verkleinernde Projektionsvorrichtung, in der ein Muster (5) auf einer Strichplatte (2) verkleinert und auf einen Wafer (4) projiziert wird, wobei das Projektionslicht direkt das Muster darauf bildet, die eine Einrichtung (3, 7) aufweist, um ein auf dem Wafer (4) gebildetes Positionierungsmuster optisch zu vergrößern und zu projizieren und um es abzubilden auf einer Abbildungsebene mit einer Schlitzeinrichtung (8), einer Trageinrichtung (18), um den Wafer (4) darauf zu setzen und die in einer vorbestimmten Richtung beweglich ist, einer Längenmeßeinrichtung (16), um die Position der Trageinrichtung (18) in der besagten Richtung zu messen, und einer Einrichtung (9), um fotoelektrisch den Lichtstrom des Lichtes zu messen, das durch die Schlitzeinrichtung (8) hindurchtritt, und Einrichtungen (15, 16, 17, 22, 23, 24), um die relative Position zwischen dem Positionierungsmuster auf dem Wafer (4) und der Schlitzeinrichtung (8) zu berechnen, dadurch gekennzeichnet, daß die Schlitzeinrichtung (8) fest auf der optischen Achse des Vergrößerungssystems (7) montiert ist, und daß die relative Position zwischen dem Positionierungsmuster auf dem Wafer (4) und der Schlitzeinrichtung (8) erfaßt wird durch fotoelektrisches Messen des Lichtstroms des Lichtes, das durch die Schlitzeinrichtung (8) in Abhängigkeit von der Bewegung der Trageinrichtung (18) hindurchtritt.

2. Ausrichtsystem für eine verkleinernde Projektionsvorrichtung nach Anspruch 1, gekennzeichnet durch Einrichtungen, um die Strichplatte (2) mit dem neu zu bildenden Muster zu bewegen und zu positionieren, um sich mit der Position des Wafers (4) zu decken.

3. Ausrichtsystem für eine verkleinernde Projektionsvorrichtung nach Anspruch 1 oder 2, dadurch gekennzeichnet, daß die Längenmeßeinrichtung ein Laser-Interferometer (16) aufweist.

**Revendications**

1. Système d'alignement avec projection à échelle réduite, dans lequel un dessin (5) situé sur un réticule (2) est réduit et est projeté sur une pastille (4), la lumière de projection reproduisant directement le dessin sur cette pastille, et comprenant des moyens (3, 7) pour réaliser le grossissement optique et la projection d'un dessin de positionnement formé sur la pastille (4) et pour former une image dans un plan de formation d'images, comportant des moyens à fente (8), des moyens en forme de socle (18) sur lesquels on dispose la pastille (4) et qui sont déplaçables dans une direction prédéterminée, des moyens (16) de mesure de longueur pour mesurer la position des moyens formant socle (18) dans ladite direction et des moyens (9) pour mesurer par voie photoélectrique le flux lumineux de la lumière traversant les moyens à fente (8), et des moyens (15, 16, 17, 22, 23, 24) pour calculer la position relative entre le dessin de positionnement situé sur la pastille (4) et les moyens à fente (8), caractérisé en ce que les moyens à fente (8) sont montés fixes sur l'axe optique du système de grossissement (7) et que la position relative entre le dessin de positionnement situé sur la pastille (4) et les moyens à fente (8) est détectée par mesure photoélectrique du flux lumineux de la lumière traversant les moyens à fente (8) en fonction du déplacement des moyens formant socle (18).

2. Système d'alignement à projection à échelle réduite selon la revendication 1, caractérisé par des moyens permettant de déplacer et de positionner le réticule (2), comportant le dessin devant être à nouveau reproduit, de manière qu'il coïncide avec la position de la pastille (4).

3. Système d'alignement à projection à échelle réduite selon la revendication 1 ou 2, caractérisé en ce que les moyens de mesure de longueur comprennent un interféromètre laser (16).

FIG. 1
PRIOR ART

FIG. 3

**FIG. 2**

ENCODER (13') → COUNTER (13) → DIFFERENTIATION CIRCUIT (14) → A-D CONVERTER (15)

ORIGIN SENSOR (16') → COUNTER (21)

PHOTO MULTIPLIER (9)

LASER INTERFEROMETER (16)

A-D CONVERTER (15), COUNTER (21) → DATA MEMORY (22) → CPU (17)

**FIG. 4**

LASER INTERFEROMETER (16) → DIGITAL COMPARATER (23)

PHOTO MULTIPLIER (9) → A-D CONVERTER (15) → DATA MEMORY (22)

DIGITAL COMPARATER (23) → MEMORY (24)

LASER INTERFEROMETER (16) → CPU (17)

MEMORY (24), DATA MEMORY (22) → CPU (17)